## Europäisches Patentamt

## European Patent Office

## Office européen des brevets

(11) Veröffentlichungsnummer: **0 001 209**
A1

# (12) EUROPÄISCHE PATENTANMELDUNG

(21) Anmeldenummer: **78100654.9**

(22) Anmeldetag: **16.08.78**

(51) Int. Cl.²: **H 01 L 23/52**
H 01 L 23/50, H 01 L 27/10
H 01 L 27/02
//G11C17/00

(30) Priorität: **06.09.77 US 830715**

(43) Veröffentlichungstag der Anmeldung:
**04.04.79 Patentblatt 79 7**

(84) Benannte Vertragsstaaten:
**DE FR GB**

(71) Anmelder: **International Business Machines
Corporation**

**Armonk, N.Y. 10504(US)**

(72) Erfinder: **Balyoz, John
Deerwood Drive
Hopewell Junction NY 12533(US)**

(72) Erfinder: **Gruodis, Algirdas Joseph
52 Edgehill Drive
Wappingers Falls NY 12590(US)**

(74) Vertreter: **Böhmer, Hans Erich, Dipl.-Ing. et al,
Schönaicher Strasse 220
D-7030 BÖblingen(DE)**

(54) **Integrierte Halbleiterschaltung.**

(57) Planare integrierte Halbleiterschaltung, bei der das Layout der Verdrahtungskanäle auf der Halbleiteroberfläche unabhängig ist von dem Layout der aktiven Schaltkreise und Bauelemente innerhalb des Halbleitersubstrats. Auf diese Weise kann die dichte Anordnung und oder die Unterbringung der Verdrahtungskanäle auf der Oberfläche des Halbleiterplättchens so verändert werden, daß dadurch die Ausnutzbarkeit der Verdrahtungskanäle erhöht wird.

FIG. 2

EP 0 001 209 A1

- 1 -

## Integrierte Halbleiterschaltung

Die Erfindung betrifft integrierte Halbleiterschaltungen und insbesondere die Anordnung der integrierten Schaltkreise auf einem Halbleiterplättchen.

## Beschreibung des Standes der Technik

Es gibt im Prinzip zwei Entwurfsverfahren in der Halbleiterindustrie, nämlich Standard- oder Einheitsentwurf bzw. Einzelentwurf. Beim Standardentwurf werden Transistoren, Dioden, Widerstände usw. einer bestimmten Schaltkreisfamilie in einer Anzahl sich ständig wiederholender Zellen innerhalb eines Halbleiterplättchens untergebracht. Jede der Zellen enthält eine ausreichende Anzahl von Transistoren, Widerständen usw. zur Bildung des ausgewählten Typs von Schaltkreis, und die einzelnen Zellen sind innerhalb des Halbleiterplättchens regelmäßig angeordnet. Die Schaltkreise innerhalb des Halbleiterplättchens werden durch selektive Verdrahtung der Schaltkreise innerhalb einer ersten Metallisierungsebene auf der Oberfläche des Halbleiterplättchens zur Bildung einer bestimmten logischen Funktion oder Funktionen den besonderen Bedürfnissen angepaßt. Diese

FI 977 002

Art der Konstruktion eignet sich besonders gut für Entwurfsautomatisierung, bei welcher die Verdrahtung mehr oder weniger automatisch durchgeführt wird. Die für Entwurf, Konstruktion und Freigabe für die Fertigung eines solchen Einheitsentwurfs erforderliche Zeit ist wesentlich kleiner, als die für im Einzelentwurf herzustellende Halbleiterplättchen erforderliche Zeit.

Beim Einzelentwurf und der Einzelkonstruktion werden die einzelnen Zellen zur Durchführung einer ganz besonderen Funktion, gewöhnlich auch in einem speziellen System ausgelegt. Die Verdrahtung macht hier weniger Schwierigkeiten, da sie bereits bei der Anordnung der Schaltkreise innerhalb des Halbleiterplättchens voll berücksichtigt werden kann. Im Einzelentwurf hergestellte integrierte Halbleiterscheiben gibt es dabei oft nur einmal, und sie werden dann in großen Mengen hergestellt. Eine Veränderung der logischen Funktion ist dabei außerordentlich schwierig und wird selten unternommen.

Bei jeder dieser Konstruktionen muß ein relativ hoher Anteil der Halbleiteroberfläche für die Verdrahtung der Schaltkreise vorgesehen sein. Die Ausnutzung dieser Verdrahtung ist für die beabsichtigten Zwecke nicht besonders wirkungsvoll. Dies hatte zur Folge, daß bei hochintegrierten Halbleiterschaltungen die erreichbaren Schaltungsdichten durch die Fläche beschränkt waren, die für die Verdrahtung vorgesehen war, eine Fläche, die man sonst für weitere Bauelemente innerhalb des Halbleiterplättchens vorsehen könnte. Die Verdrahtung auf der Oberfläche einer Halbleiterscheibe besteht aus Verbindungen zwischen den Bauelementen, aus Versorgungsleitungen und aus Signalleitungen. Die innerhalb des Halbleiterplättchens für Verbindung zwischen verschiedenen funktionellen Schaltungen, genannt Makros, und zwischen den einzelnen Halbleiterplättchen benutzte Verdrahtung wird allgemein als Globalverdrahtung bezeichnet. Die Fläche eines Halbleiterplättchens, die durch diese Globalverdrahtung belegt wird, hängt von der Art des Halbleiterplättchens, also logische Schaltung oder Speicher, den während des Herstellungsverfahrens zu beobachtenden Regeln und der Anzahl der für die Durchführung der Verdrahtung auf der Oberfläche des Halbleiterplättchens zur Verfügung stehenden Metallisierungsebenen ab.

Über die Wirksamkeit dieser Verdrahtung weiß man sehr wenig. Es wurde bei der Anmelderin festgestellt, daß bei Benutzung von zwei Metallisierungsebenen für die globale Verdrahtung etwa 30 % der Halbleiteroberfläche für die aktiven Schaltungen innerhalb des Substrats benutzt wird, und daß die restlichen 70 % für die globale Verdrahtung reserviert sind. Selbst bei technisch ausgefeilten Entwurfsautomatisierungsverfahren werden bei Durchführung der Verdrahtung nur etwa 60 % der für die globale Verdrahtung reservierten Fläche tatsächlich ausgenutzt. Somit bleiben etwa 40 % der Halbleiteroberfläche unbenutzt.

Die Schwierigkeit liegt beim Entwurf und der Konstruktion der Schaltkreiszellen, die auf dem Halbleiterplättchen untergebracht werden sollen. Ganz allgemein enthält jede der Zellen einen aktiven Bereich und einen Platz für mehrere Verdrahtungskanäle, wo dann die Verdrahtung innerhalb der Zelle, innerhalb der Schaltkreise und die gesamte globale Verdrahtung untergebracht werden können. Die Zellen sind dabei in engbenachbarten Spaltenanordnungen untergebracht, um möglichst viele solche Zellen auf einem Halbleiterplättchen unterbringen zu können. Diese Anordnung ist jedoch viel zu starr.

Insbesondere schwankt die Dichte von gut entwickelten Verdrahtungsmustern mit dem Ort auf dem Halbleiterplättchen. Im allgemeinen werden in der Mitte des Plättchens wesentlich mehr Leitungen benötigt, als beispielsweise am Rand. Wenn diese Anzahl von Leitungen die innerhalb einer Zelle zur Verfügung stehenden Verdrahtungskanäle überschreitet, kann die Zelle nicht benutzt werden. Dies hatte den bereits erwähnten schlechten Wirkungsgrad bei der Ausnutzung von Zellen und Verdrahtungsraum zur Folge.

Die US-Patentschrift 4 032 962, die der Deutschen Patentanmeldung P 26 55 575 der Anmelderin entspricht, zeigt eine Anordnung, wie die Verdrahtung mit höherem Wirkungsgrad ausgenutzt werden kann. In dieser Patentschrift sind Halbleiterschaltungen offenbart, die in Spalten innerhalb des Substrats angeordnet sind, wobei jeder Schaltkreis eine langgestreckte, dotierte Zone und eine Gruppe von anderen dotierten Zonen aufweist, die sich zur Bildung von Diodenübergängen an die erstgenannte Zone anschliessen. Die langgestreckte Zone kann dabei eine vorbestimmte größte Anzahl anderer Zonen aufnehmen. Anschließend an die Schmalseite der ersten Vorrichtung ist eine zweite Vorrichtung vorgesehen. Eine erste Gruppe von Leitungszügen einer ersten Leitungsebene erstreckt sich über die langgestreckte Zone und senkrecht zur Längsausdehnung dieser Zone, wobei diese Leitungen an ausgewählten der anderen dotierten Zonen angeschlossen sind. Ein anderer Leiter in einer zweiten Metallisierungsebene auf dem Substrat ist mit einer dotierten Zone der zweiten Vorrichtung verbunden und erstreckt sich im wesentlichen parallel zur Längs-

FI 977 002

richtung der ersten Zone. Auf diese Weise können zahlreiche Leitungen, ob sie nun durch eine bestimmte Schaltung benutzt werden oder nicht, über den aktiven Bereich innerhalb des durch die Halbleiterzellen benutzten Substrats geführt werden. Diese Art von Anordnung hat die Schaltungsdichte innerhalb des Halbleiterplättchens wirksam erhöht. Diese Anordnung ist jedoch nicht auf eine optimale Ausnutzung der für die Verdrahtung allein vorgesehenen Oberfläche des Halbleiters ausgerichtet.

Gesamtdarstellung der Erfindung

Aus dieser Darstellung läßt sich die der Erfindung zugrunde liegende Aufgabe in allgemeiner Form ableiten, nämlich die Ausnutzung der Oberfläche eines Halbleiterplättchens weiter zu verbessern und dabei insbesondere die auf der Halbleiteroberfläche für die globale Verdrahtung freizuhaltende Fläche weiter zu verringern.

Diese der Erfindung zugrunde liegende Aufgabe wird zunächst dadurch gelöst, daß man auf dem Halbleiterplättchen die für die globalen Verdrahtungskanäle freizuhaltende Fläche, von der für die aktiven Schaltkreise und deren Verdrahtung freizuhaltende Fläche trennt. Jede dieser beiden Flächen wird dann in kleinere Bereiche unterteilt, die als aktive Zellen und als Verdrahtungszellen bezeichnet werden sollen. Die aktiven Zellen dienen, wie schon der Name sagt, zur Aufnahme der aktiven Schaltkreise, und die Verdrahtungszellen werden zunächst vorrangig für globale Verdrahtungskanäle benutzt. Diese Zellen sind bezüglich ihrer Abmessungen auf vorbestimmte Verhältnisse zueinander ausgelegt, und zwar in einer vorher festgelegten Weise, vor der eigentlichen Herstellung der tatsächlichen Verdrahtung auf dem Halbleiterplättchen.

FI 977 002

Gemäß einem Gesichtspunkt bei diesem neuen Verfahren wird beim Entwurf der Verdrahtung zunächst eine Anordnung von Schaltkreisen vorgenommen, die verschiedene bestimmte Funktionen zu erfüllen haben. Beim Entwurf kann vor dem eigentlichen Fertigungsverfahren der Konstrukteur diese Teile der Bereiche innerhalb eines oder mehrerer Makros nur für die Verdrahtung benutzen. Er kann die einzelnen Makros mit einer ausreichenden Anzahl von Verdrahtungszellen versehen, so daß die Verdrahtungskanäle vollständig hindurchlaufen, wodurch der Abstand der Verdrahtung zwischen den Makros möglichst klein gehalten wird. Im Stand der Technik hätte die Verdrahtung rundherum um ein Makro geführt werden müssen.

Ganz allgemein besteht das Layout aus einer Anzahl von auf Abstand stehenden Schaltkreisen oder Zellen und ersten und zweiten im wesentlichen parallel verlaufenden langgestreckten Leitern, die auf einer ersten Isolierschicht liegen. Die erste Gruppe von Leitern liegt unmittelbar oberhalb der aktiven Schaltkreise, und die zweite Gruppe von Leitern liegt in den für die Verdrahtung freigehaltenen Bereichen zwischen den Schaltkreisen. Ausgewählte Anschlüsse der ersten Gruppe von Leitern sind über in der ersten Isolierschicht vorgesehenen Bohrungen mit ausgewählten Zonen der aktiven Bauelemente oder Schaltkreise verbunden. In der bevorzugten Ausführungsform erstreckt sich eine dritte Gruppe von Leitern senkrecht zu der ersten und zweiten Gruppe von Leitern und ist über einer zweiten Isolierschicht angebracht.

Die Erfindung wird nunmehr anhand von Ausführungsbeispielen in Verbindung mit den beigefügten Zeichnungen im einzelnen beschrieben.

FI 977 002

In den Zeichnungen zeigt

Fig. 1          eine Dioden-Transistor-Logik-Schaltung des
                Standes der Technik, die eine NAND-
                Funktion erfüllt,

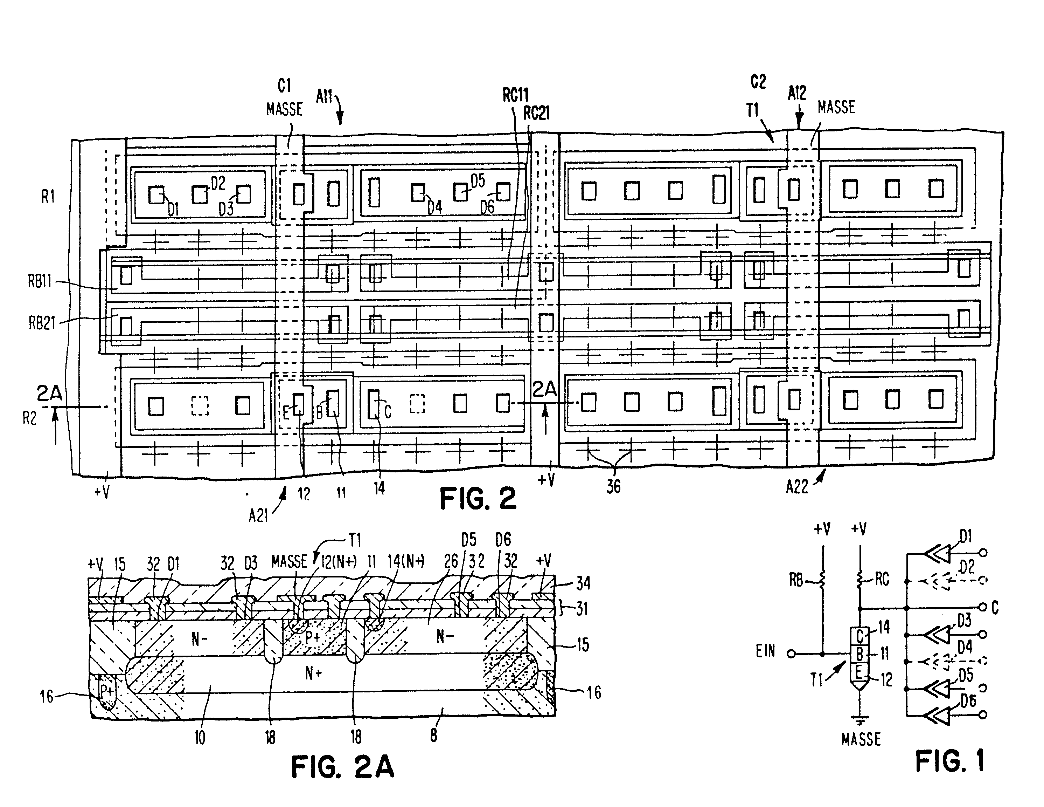

Fig. 2 und 2A   sind Draufsicht und Querschnittsansicht
                eines Satzes von Zellen
                der in Fig. 1 dargestellten Schaltung,

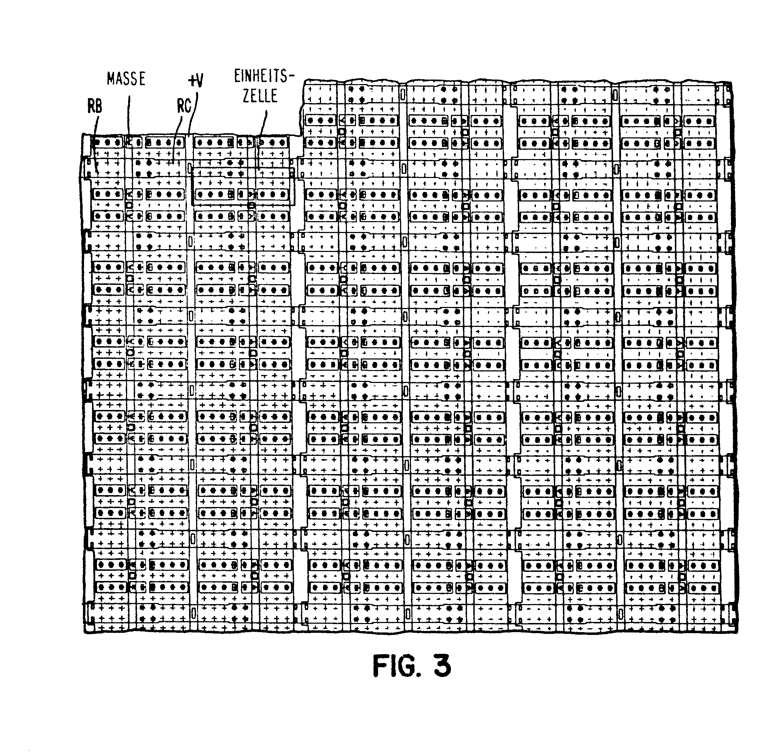

Fig. 3          einen Teil einer Anordnung auf einem
                Halbleiterplättchen mit einer Anzahl von
                Zellen, wie sie Fign. 2 und 2A zeigen,

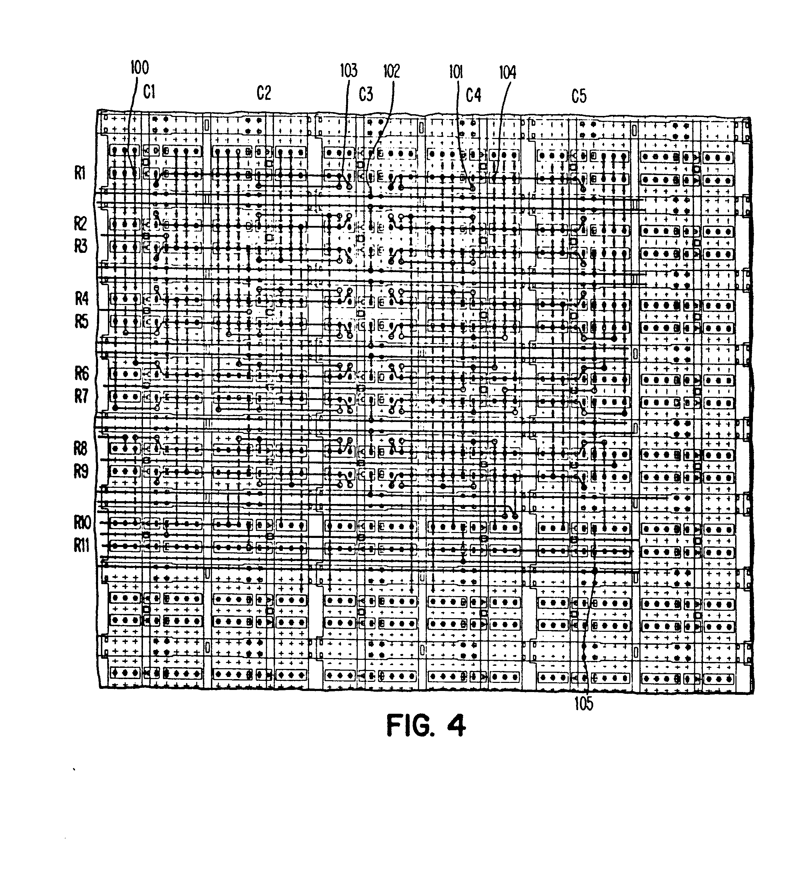

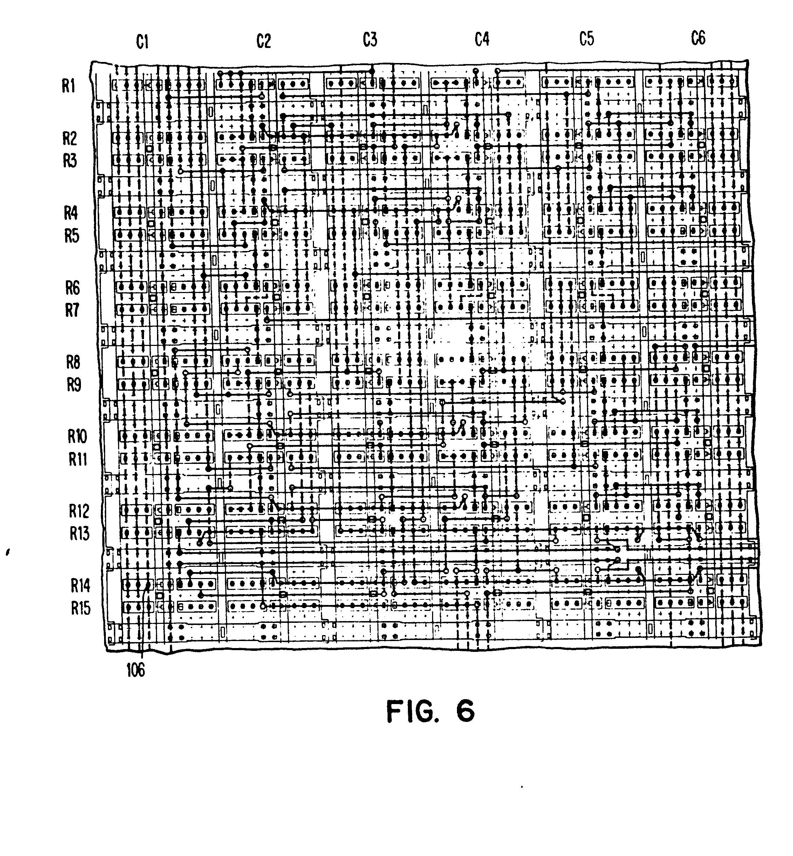

Fig. 4          ein Draufsicht auf einen Teil einer komplexen integrierten Schaltungsanordnung
                für eine Makro-Funktion, wobei die erste
                und zweite Ebene der Metallisierung bereits aufgebracht ist,

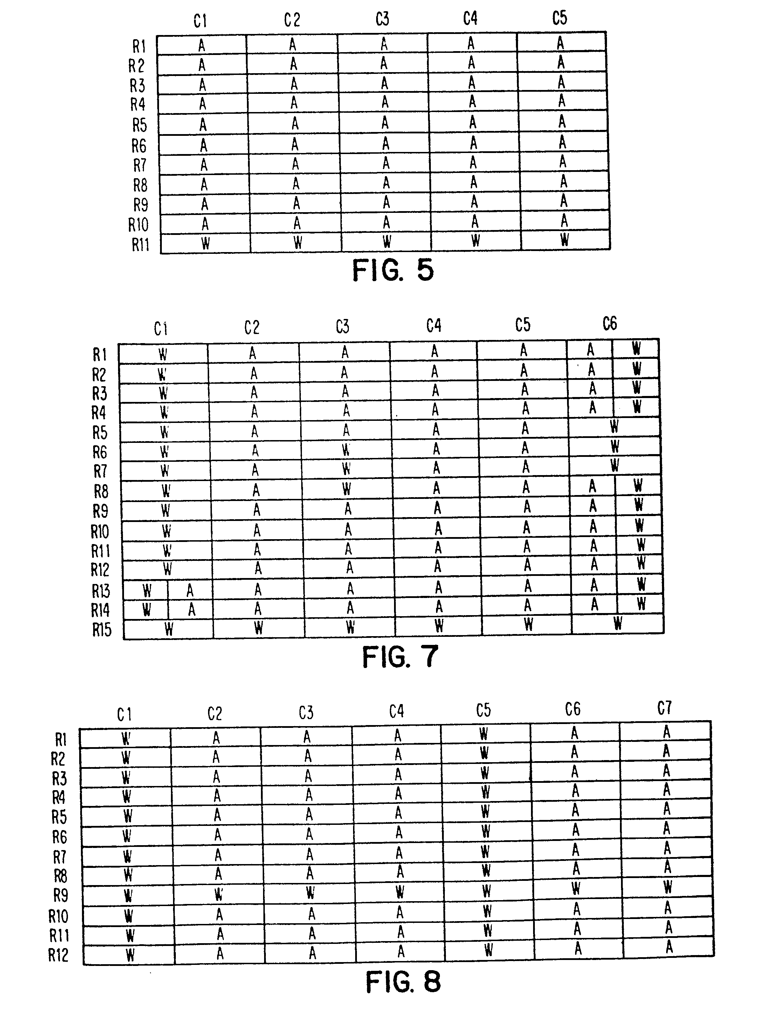

Fig. 5          eine schematische Darstellung der Fig. 4
                mit den aktiven Zellen und den Verdrahtungszellen,

Fig. 6          eine Draufsicht einer komplexen integrierten Schaltungsanordnung für eine
                andere Makro-Funktion, bei welcher die
                erste und zweite Metallisierungsebene bereits aufgebracht ist,

Fig. 7          eine schematische Darstellung von Fig. 6
                mit der Angabe der aktiven und der Ver-
                drahtungszellen,

FI 977 002

Fig. 8          eine schematische Darstellung eines
                Makros als arithmetische und logische Einheit unter Angabe der zur Bildung des
                Makros verwendeten aktiven Zellen und Verdrahtungszellen,

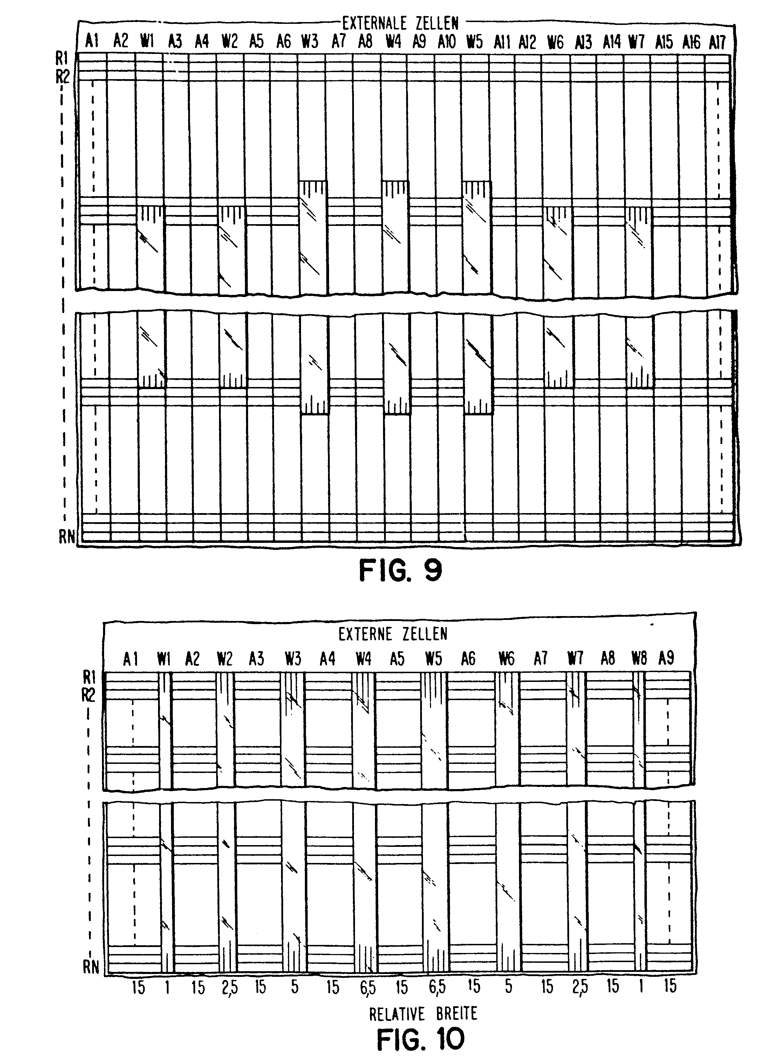

Fig. 9 und 10   schematische Darstellungen eines vollständigen Halbleiterplättchens, bei dem
                die Anzahl der Verdrahtungszellen in der
                Mitte des Halbleiterplättchens größer ist
                als im Randbereich.

Beschreibung von bevorzugten Ausführungsformen

Fig. 1 zeigt eine bekannte, als NAND-Glied arbeitende
DTL-Schaltung. Diese Schaltung ist kein Teil der Erfindung und ist dem Halbleiterfachmann gut bekannt. Ferner
sei gleich hinzugefügt, daß die Erfindung auch nicht auf
diese Art von Schaltung begrenzt ist, oder auf eine
entsprechende Anordnung in einem Halbleiterplättchen.
In der Tat ist die Erfindung auch auf weitere Schaltkreisfamilien, wie z. B. TTL, Standard DTL, ECL usw. anwendbar.

Die Schaltung selbst und ihre verschiedenen Ausgestaltungen sind in einem Aufsatz von Peltier in 1975 IEEE
International Solid-States Circuits Conference, Digest
of Technical Papers, Seiten 168-169 mit dem Titel
"A New Approach to Bipolar LSI: $C^3L$" beschrieben. Die
Schaltung besteht aus einem einzigen Transistor T1, einem
Paar Vorspannungswiderstände RB und RC, die an Basis-
bzw. Kollektor-Elektrode des Transistors T1 angeschlossen sind. Die Schaltung hat sechs anschließbare Ausgänge,
die vorzugsweise als Schottky-Sperrschichtdioden ausgestaltet sind und die dementsprechend mit D1, D2, D3, D4,

FI 977 002

- 9 -

D5, und D6 bezeichnet sind, sowie einen unmittelbaren, mit C bezeichneten Kollektoranschluß.

Die logische Schaltung arbeitet über die Steuerung des den Widerstand RB, der auch ein Transistor sein kann, durchfließenden Stroms. Sind alle Eingangssignale des Transistors T1 auf niedrigem Potential, dann ist T1 gesperrt, und die Ausgangssignale der Schottky-Sperrschichtdioden sind auf hohem Potential. Wenn eines der Eingangssignale von T1 auf hohem Potential liegt, dann leitet T1 von +V nach Masse und die Ausgangs-Schottky-Sperrschichtdioden sind leitend.

Fig. 2 und 2A sind eine Draufsicht bzw. eine Querschnittsansicht von vier mit A11, A12, A21 und A22 bezeichneten Zellen. Die Zellen sind praktisch gleichartig aufgebaut, so daß die Beschreibung einer Zelle für die Beschreibung aller Zellen steht.

Jede Zelle ist eine DTL-Schaltung gemäß Fig. 1 in integrierter Halbleiterschaltungstechnik, und besteht aus einer Anzahl von Zonen unterschiedlichen Leitungstyps, die sich in das Halbleiterplättchen hinein erstrecken und dabei Transistoren, Dioden und Widerstände bilden. Diese Zonen sind auf einer ersten, über einer ersten Isolierschicht 31 auf dem Halbleiterplättchen angebrach-

FI 977 002

ten Metallisierungsebene zur Bildung einer DTL-Grundschaltung miteinander verbunden. Für eine deutlichere
Darstellung ist ein Teil der Oberflächenverdrahtung weggelassen worden. Beispielsweise sind in Fig. 2 die Verbindungsleitungen zwischen den Widerständen RB und RC
und der Basis- bzw. Kollektor-Elektrode nicht dargestellt
und werden in den übrigen Figuren der Zeichnung auch
nicht gezeigt. Ein in der Zeichnung angebrachtes Kreuz
zeigt die Bereiche an, bei der die Verdrahtung der zweiten
Metallisierungsebene oberhalb einer zweiten Isolierschicht
34 die Verdrahtung der ersten Metallisierungsebene überkreuzen kann. Doch dies wird im folgenden noch näher erläutert. Es sei zunächst darauf hingewiesen, daß die Anordnung der Zellen in Fig. 2, 2A und 3 nicht die Erfindung darstellen. Sie zeigen jedoch die derzeit beste bekannte Möglichkeit, die Erfindung zu verwirklichen.

Transistor T1 enthält eine langgestreckte im Substrat 8
angebracht Subkollektorzone 10, eine Basiszone 11 und
eine in einer Epitaxialschicht 26 gebildete Emitterzone 12.
Symmetrisch zu beiden Seiten des Transistors T1 sind in
der Epitaxialschicht 26 Schottky-Sperrschichtdioden D1,
D2 ..., D6 gebildet. Eine Kollektoranschlußzone 14 vervollständigt den Transistor T1. Isolation zwischen den
Schaltungen wird durch eine $P^+$-leitende Zone 16 und eine
eingelassene Oxidzone 15 gebildet, wie dies aus dem Stand
der Technik·bekannt ist. Die Isolierzone 18 isoliert die
Zone 14 gegen Basis 11 und Emitter 12. Wie
aus Fig. 2A zu erkennen, weisen nur diejenigen Dioden,
die tatsächlich in der Schaltung eingeschaltet sind,
eine Metallisierung auf, die für die Bildung der Dioden
erforderlich ist. Somit ist also die Anzahl der Störatomzonen, die tatsächlich an den Verbindungleitungen 32
angeschlossen sind, kleiner, als die größtmögliche Anzahl von Dioden, die auf diese Weise angeschlossen werden könnten. Diese Zelle, die nicht die Erfindung selbst ist,
ist ähnlich der Zelle, die in der US-Patentschrift
4 032 962 der Anmelderin offenbart ist. Anschlußleitungen,
die mit +V und Masse bezeichnet sind, liefern die Bezugspotentiale für jede Schaltung und sind oberhalb der
Isolierschicht 31 zur Längsrichtung der Zelle senkrecht
verlaufend angebracht. Die Widerstände RB und RC liegen
in langgestreckter Form an beiden Längsseiten einer
jeden Zelle. Die die Zellen miteinander verbindenden
Leitungen werden in einer ersten und einer zweiten Metallisierungsebene hergestellt und bilden funktionale Einheiten, die hier mit Makros bezeichnet werden. Die Globalverdrahtung verbindet die verschiedenen Makros untereinander. Diese Leiter sind in Fig. 2 der Klarheit halber
nicht gezeigt. Die zweite Ebene von Leitungen ist von
der ersten Ebene von Leitungen durch die Isolierschicht
34 getrennt. Die Überkreuzungen der Leitungen der ersten
und der zweiten Ebene sind in Fig. 2 mit den Bezugszeichen 36 gekennzeichnet. In der bevorzugten Ausführungsform enthält jede Zelle außerdem Platz für langgestreckte
leitende Kanäle der zweiten Ebene, die sich parallel
zur Längsrichtung der Zelle und der Widerstände erstrecken.

Wie bereits erläutert, wird für die Schottky-Sperrschichtdioden eine leitende Verbindung zu den innerhalb
des Substrats gelegenen Zonen durch leitende Kanäle der
ersten Metallisierungsebene hergestellt, die senkrecht
zu den Leitungen der zweiten Ebene und senkrecht zur
Längsrichtung der Zelle verlaufen.

Fig. 3 zeigt auf einem Halbleiterplättchen eine Anordnung
von Zellen, wie sie in Fign. 2 und 2A gezeigt sind.

FI 977 002

Wie man erkennt, sind die Zellen spaltenweise angeordnet und dies über das gesamte Halbleiterplättchen, mit Ausnahme der Randbereiche, die für (nicht gezeigte) außenliegende Zellen erforderlich sind, worunter Treiberstufen, Eingangsstufen und Versorgungsleitungen zu verstehen sind. Die Einheitszelle ist in Fig. 3 umrandet dargestellt. Hunderte dieser Zellen sind in Spaltenanordnungen auf dem Halbleiterplättchen vorgesehen. Derzeit werden mehr als 1900 solcher Zellen auf einem einzigen Halbleiterplättchen hergestellt, dessen Abmessungen 3,8 x 3,8 mm betragen. Jede Zelle ist dabei etwa 0,1 bis 0,13 mm lang und 0,03 - 0,05 mm breit. In Fig. 3 sind die Zellen nicht verdrahtet und können daher noch nicht als aktive Schaltungen arbeiten.

Für die Verdrahtung kann jede Schaltkreiszelle als ganzes oder als zwei Zellen betrachtet werden, die in eine aktive und eine Verdrahtungszelle unterteilt sind. Dies wird im folgenden noch näher erläutert.

Wie bereits erwähnt, ist der Widerstand RB einmal an der Basis-Elektrode des zugehörigen Transistors T1 und dann an einer Spannungsquelle +V angeschlossen. In gleicher Weise ist der Widerstand RC einmal an der zugeordneten Kollektor-Elektrode und an +V angeschlossen. Ebenso ist der Emitter eines jeden Transistors mit Erdpotential verbunden.

Fig. 4 zeigt einen Teil eines Halbleiterplättchens, das erfindungsgemäß verdrahtet ist. Die Anordnung von fünf Spalten C1-C5 und 11 Zeilen R1-R11 zeigt den Teil eines Halbleiterplättchens, das die logische Makrofunktion eines Eingangsleitungs-Selektors, ähnlich einem Decodierer durchzuführen vermag. Im Betrieb nimmt diese Makroschaltung von den Eingangsstufen des Halbleiterplättchens kommende Signale auf, decodiert diese Signale und überträgt sie nach verschiedenen anderen Makros innerhalb des Halbleiterplättchens.

Integrierte Schaltungsanordnungen und Schaltungen, die solche Makrofunktionen auszuführen vermögen, sind im Stand der Technik bekannt. Es sei beispielsweise auf die US-Patentschrift 4 006 492 für die Anordnung verschiedener Makros verwiesen. Ebenso auf die US-Patentschrift 3 558 992.

In Fig. 4 sind die gestrichelten Linien, die senkrecht zur Längsrichtung der Zellen und parallel zur Richtung der Spaltenanordnung verlaufen, über der ersten Isolierschicht 31 über den aktiven Bereichen des Halbleiterplättchens gebildete Leiter. Die ausgezogenen parallelen Linien, die sich im allgemeinen längs der Längsrichtung der Zellen erstrecken und senkrecht zu den Leitungen der ersten Ebene verlaufen, sind auf der zweiten Isolierschicht 34, die über den Leitern der ersten Ebene liegt, hergestellte Leiter. Kontakte zwischen den Leitern der ersten Ebene und ausgewählten aktiven Halbleiterzonen innerhalb der Zellen werden durch Bohrungen oder Öffnungen in der ersten Isolierschicht hergestellt, die durch ausgefüllte Quadrate dargestellt sind, wie z. B. bei 100 angedeutet.

Die aktiven Zonen in diesem Beispiel sind die Basis und der Kollektor des Transistors und die Dioden in jeder der Zellen. Selbstverständlich werden in Zellen, die andere Schaltungsfunktionen auszuführen haben, wie z. B. TTL, ECL usw. die aktiven Zonen von anderer Art dotierte Zonen sein. Da in dieser bevorzugten Schaltungszelle die

FI 977 002

Emitter der Transistoren und beide Widerstände für jede aktive Zelle verdrahtet sind, sind diese Kontakte der Klarheit halber nicht dargestellt.

Kontakte zwischen zweiter Metallisierungsebene und erster Metallisierungsebene werden über die zweite Isolierschicht durchsetzende durchgehende Bohrungen hergestellt, die in Fig. 4 durch einen offenen Kreis etwa bei 101 angedeutet sind.

Aus Verfahrensüberlegungen werden Kontaktverbindungen nicht unmittelbar von Leitern der zweiten Metallisierungsebene nach den aktiven Zonen hergestellt. Wo eine solche Verbindung hergestellt wird, da wird zunächst ein Leiter der zweiten Metallisierungsebene über eine durchgehende Bohrung in der zweiten Isolierschicht mit einem Leiter der ersten Metallisierungsebene verbunden. Dieser Leiter der ersten Metallisierungsebene stellt dann über eine metallisierte Bohrung in der ersten Isolierschicht eine Verbindung mit der aktiven Zone her. Dies ist beispielsweise in Fig. 4 bei 102 gezeigt.

An solchen Stellen, wo die zweite Metallisierungsebene mit einem Leiter der ersten Metallisierungsebene verbunden ist, der wiederum an einer aktiven Zone angeschlossen ist, und der Leiter der zweiten Metallisierungsebene diesen Kontakt überkreuzt, ist der Leiter durch eine schräge Linie angedeutet, wie bei 103 in Fig. 4.

Dies ist nur für eine klarere Darstellung gedacht. In Wirklichkeit liegt der Leiter der zweiten Metallisierungsebene unmittelbar über dem Leiter der ersten Metallisierungsebene und ist von diesem nur durch die zweite Isolierschicht getrennt.

FI 977 002

An anderen Stellen, wo kein Leiter der zweiten Metallisierungsebene einen Kontakt der ersten Metallisierungsebene überkreuzt, trennt die zweite Isolationsschicht die beiden voneinander, wie dies bei 104 gezeigt ist.

Beim Metallisierungsverfahren besteht die erste Isolierschicht 31 im allgemeinen aus einer Doppelschicht aus Siliciumdioxid und Siliciumnitrid. Selbstverständlich könnten mit ebenso guten Ergebnissen andere dielektrische Schichten als erste Isolierschicht verwendet werden. Die erste Ebene der Metallisierung, die sowohl die ohmschen Kontakte nach den dotierten Zonen des Transistors als auch die nicht-ohmschen Kontakte nach den Schottky-Sperrschichtdioden herstellt, besteht aus einer ersten Chromschicht mit einer Dicke von etwa 0,1 Mikrometer, einer darauf niedergeschlagenen Platinschicht, gefolgt von einer Aluminiumschicht oder einer Schicht aus einer Aluminum-Kupfer-Legierung und Silicium. Andere Arten der Metallisierung können ebenfalls benutzt werden. Vorzugsweise besteht der Schottky-Sperrschicht-Diodenkontakt für Schottky-Sperrschichtdioden mit einer Potentialschwelle von etwa 0,5 eV aus einer Schicht aus Tantal und einer Schicht aus Chrom, über denen die Aluminium-Metallisierung liegt. Aluminium bildet dabei die erste Metallisierungsebene von Verbindungsleitungen und wird nach üblichen Masken- und Ätzverfahren hergestellt.

Nachdem die erste Metallisierungsebene gebildet ist, wird die zweite Isolierschicht 34, beispielsweise aus Quarz, niedergeschlagen und liefert damit eine Isolation zwischen der bereits vorhandenen ersten Metallisierungsebene und der zweiten Metallisierungsebene. In der aus Quarz oder Glas bestehenden Isolierschicht 34 werden durchgehende Bohrungen an den Stellen hergestellt, wo Verbindungen zwischen der zweiten Metallisierungsebene und der ersten Metallisierungsebene hergestellt werden sollen.

Besonders bemerkenswert an dem in Fig. 4 dargestellten Makro ist, daß die gesamte letzte Zeile R11 ausschließlich für die Verdrahtung der zweiten Metallisierungsebene vorgesehen ist und damit eine Globalverdrahtung zwischen dem dargestellten Makro und anderen nicht gezeigten Makros bildet. Tatsächlich sind keine aktiven Zonen einer Zelle innerhalb des Substrats in Zeile 11 und Spalten C1-C5 längs dieser Zeile durch Verdrahtungen der ersten oder zweiten Metallisierungsebene kontaktiert. Andererseits werden alle anderen Zellen innerhalb dieses Makros mit Ausnahme R10/C3 als aktive Schaltungen benutzt. Es werden also Verbindungen von der Verdrahtung der ersten Metallisierungsebene nach mindestens einer aktiven Zone einer jeden Zelle hergestellt, die nicht ausschließlich für Verdrahtung benutzt wird.

Jeder der Leiter der zweiten Metallisierungsebene in Zeile R11 ist mit dem Kollektor eines zugeordneten Transistors in den Zellen der Zeile R10 über eine Leitung der ersten Metallisierungsebene verbunden, wie z. B. bei 105. Daher bilden die Leiter der ersten und zweiten Metallisierungsebene in R11 Teil eines aus 5 x 11 Zellen bestehenden Makros, liegen jedoch in Bereichen, die keine freiliegenden aktiven Zellen enthalten. Dies stellt ein hochwirksames Verdrahtungssystem dar, da im anderen Fall die Verdrahtung durch andere, an aktiven Zonen angeschlossene Verdrahtungen unterbrochen würde, wodurch in eben dieser Verdrahtung um die Zellen herumführende Leitungsführungen vorgesehen werden müßten.

Es erscheint praktisch, nicht-freiliegende Bereiche, über die eine Verdrahtung läuft, als Verdrahtungszellen (W) zu bezeichnen, verglichen mit aktiven Zellen (A), bei denen die aktiven Zonen durch Öffnungen oder Bohrungen in der ersten Isolierschicht 31 mit der Verdrahtung verbunden sind.

Eine vereinfachte Anordnung dieser Art zeigt Fig. 5, bei der jede Zelle entweder mit A als aktive Zelle oder W als Verdrahtungszelle bezeichnet ist.

Fig. 6 zeigt eine etwas komplizierter aufgebaute Makroschaltung, die für insgesamt 90 solcher Zellen 6 Spalten mit je 15 Zellen zeigt. Dieses Makro ist ein 4-Bit-Adressregister mit wahren und komplementären Ausgangssignalen und Paritätsbit-Generatoren. Der wesentliche Gesichtspunkt dieser Anordnung ist die Verwendung von Zellen sowohl als aktive Zellen als auch als Verdrahtungszellen. Beispielsweise wird die linke Seite der in Spalte C1 und Zeile R14 liegenden Zelle 106 nur für die Verdrahtung der ersten Ebene benutzt. Diese Gruppe von Leitungen ist dabei in einem Bereich der Zellen in Spalte C1 angeordnet, die nicht freiliegen. Keiner der Schottky-Diodeneingänge der linken Seite der Schaltkreiszellen an den Stellen C1/R13 und R14 sind an die Verdrahtung angeschlossen, obgleich andererseits nur die rechten Seiten dieser Zellen als aktive Zellen benutzt werden. Die übrigen Zellen in dieser Spalte werden nur für die Verdrahtung benutzt. Es verläuft daher in Spalte 1 durch das Makro hindurch ein vollständiger Verdrahtungskanal der ersten Metallisierungsebene. Ein ähnlicher Kanal ist in Spalte C6 vorhanden.

Fig. 7 zeigt nunmehr in vereinfachter Form die Anordnung, wo neben einer durchlaufenden Anordnung von Verdrahtungszellen am Umfang oder am Rande des Makros außerdem einzelne Verdrahtungszellen innerhalb des Makros vorge-

FI 977 002

sehen sind, wie zum Beispiels bei C3/R6, C3/R7 und C3/R8.

In Fig. 8 ist die schematische Anordnung eines Makros gezeigt, bei dem die Verdrahtung der zweiten Metallisierungsebene in einer gesamten Zeile R9 quer über das ganze Makro geht. Außerdem liefert die Verdrahtung der ersten Metallisierungsebene in Spalte C5 einen ähnlichen Verdrahtungskanal für spaltenweise angeschlossene Signalleitungen durch das Makro. Alle aktiven Zellen sind voll ausgenutzt und die globale Verdrahtung kann nicht durch die aktiven Zellen hindurchgehen. Wenn man Verbindungsleitungen durch das Makro hindurchführen läßt, statt um das Makro herum, wird die Länge der Verdrahtung verringert, wobei sich gleichzeitig als weitere Vorteile ein geringerer Flächenbedarf und kleinere Spannungsabfälle ergeben.

Wie in der Zusammenfassung der Erfindung dargelegt, wird die Schaltungsdichte auf modernen Halbleiterschaltungsplättchen durch die für die gegenseitige Verbindung der Schaltungszellen erforderliche Verdrahtung begrenzt. Die meisten Schaltungsentwürfe fordern, daß in der Nähe des Mittelpunktes des Halbleiterplättchens eine größere Dichte von Leitungen vorzusehen ist, als am Umfang. Die vorliegende Erfindung gestattet eine größere Verdrahtungsdichte in der Mitte des Halbleiterplättchens im Vergleich mit dem Umfang und läßt außerdem andere Lösungsmöglichkeiten für die Anordnung von Zellen auf dem gesamten Halbleiterplättchen zu.

In Fig. 9 haben die Verdrahtungszellen die gleiche Fläche wie die aktiven Zellen, wie in den vorhergehenden Ausführungsformen in bezug auf Makros, und es sind mehr Verdrahtungszellen der gleichen Fläche in der Mitte des Halbleiterplättchens angeordnet als am Umfang. Dadurch kann eine größere Anzahl von Leitungen in der Nähe des Mittelpunktes des Halbleiterplättchens vorgesehen sein.

In Fig. 10 sind die relativen Flächen einer jeden Verdrahtungszelle unterschiedlich gewählt, so daß die Fläche einer einzelnen Verdrahtungszelle in der Mitte des Halbleiterplättchens größer ist als die Fläche einer Verdrahtungszelle am Umfang. Tatsächlich sind verschiedene Abänderungen dieser Anordnung möglich und würden trotzdem noch unter die Erfindung fallen. Beispielsweise sind die in Fig. 9 und 10 gezeigten Verdrahtungszellen für die erste Metallisierungsebene der Verdrahtung gedacht, doch läßt sich diese Anordnung genau so für die orthogonal liegende Verdrahtung der zweiten Metallisierungsebene verwenden.

FI 977 002

- 1 -

PATENTANSPRÜCHE

1.  Integrierte Halbleiterschaltung mit in Spalten auf
    Abstand voneinander angeordneten Schaltkreiszellen
    und einer ersten, mit nach aktiven Zonen ausgewählter Zellen führenden durchgehenden Bohrungen versehenen Isolierschicht,
    dadurch gekennzeichnet,
    daß auf dieser ersten Isolierschicht (31) eine
    erste und eine zweite Gruppe von langgestreckten
    Leitern im wesentlichen parallel zueinander angeordnet sind, wobei die erste Gruppe von Leitern über
    den aktiven Zellen (A) angeordnet und durch die Bohrungen mit den ausgewählten aktiven Zonen (11, 14)
    verbunden ist, während die zweite Gruppe von Leitern
    in den Bereichen zwischen den aktiven Zellen angeordnet ist,
    daß ferner über dieser ersten und zweiten Gruppe von
    Leitern eine zweite Isolierschicht (34) vorgesehen ist, auf der sich eine dritte Gruppe von im
    wesentlichen zueinander parallel verlaufenden,
    langgestreckten Leitern in einer Richtung erstreckt,

FI 977 002

die zur Richtung der ersten und zweiten Gruppe von Leitern senkrecht verläuft, wobei über durchgehende Bohrungen in der zweiten Isolierschicht (34) an ausgewählten Stellen zwischen den Leitern der dritten Gruppe und den Leitern der ersten und zweiten Gruppe Kontaktverbindungen (101) hergestellt sind.

2. Anordnung nach Anspruch 1, dadurch gekennzeichnet, daß zwischen den aktiven Zellen (A) nicht ausgenutzte Zellen liegen.

3. Anordnung nach Anspruch 1, dadurch gekennzeichnet, daß die dritte Gruppe von Leitern eine Anzahl von Leitern enthält, die zwischen den aktiven Zellen angeordnet sind.

4. Anordnung nach Anspruch 2, dadurch gekennzeichnet, daß die Leiter und die aktiven Zonen der Zellen zu einer eine Makrofunktion darstellenden Schaltung miteinander verbunden sind und daß die genannte Anzahl von Leitern praktisch über eine ganze Zeile (R15) der Makroschaltung verläuft.

5. Anordnung nach Anspruch 1, dadurch gekennzeichnet, daß die Leiter und die aktiven Zonen zu einer Makroschaltung miteinander verbunden sind und daß die zweite Gruppe von Leitern praktisch über eine ganze Spalte (C1, C5) verläuft.

6. Anordnung nach Anspruch 1, dadurch gekennzeichnet, daß die dritte Gruppe von Leitern selektiv die zweite Gruppe von Leitern mit anderen aktiven Zonen von Zellen über Kontaktverbindungen (100, 101, 102) in der ersten und zweiten Isolierschicht verbindet.

FI 977 002

7. Anordnung nach Anspruch 1, dadurch gekennzeichnet, daß jede Zelle eine rechteckige Dioden-Transistor-Logik (DTL)- Zelle mit einem Transistor (T1) und einer mit vielen Anschlüssen ausgerüsteten Diode ist, mit einer langgestreckten ersten Zone (26) und einer Gruppe von zweiten Zonen in der langgestreckten ersten Zone (26) und daß die dritte Gruppe von Leitern selektiv über die Kontakte (32) in der ersten und zweiten Isolierschicht (31, 34) Verbindungen nach den Anschlüssen der Dioden (D1 ... D6) herstellt.

8. Anordnung nach Anspruch 7, dadurch gekennzeichnet, daß einige der Leiter der zweiten Gruppe über inaktiven Bereichen der langgestreckten ersten Zonen (26) liegen, so daß ausgewählte DTL-Zellen (C1, R13, R14, C6, R1, R2, R3, R4, R8 - R15) als aktive Zellen (A) und als Verdrahtungszellen (W) dienen.

9. Anordnung nach Anspruch 1 bis 8, dadurch gekennzeichnet, daß die Zellen praktisch die ganze Oberfläche eines Halbleiterplättchens einnehmen und daß die Anzahl der Leiter der zweiten Gruppe in der Mitte des Halbleiterplättchens größer ist als am Rande.

10. Anordnung nach Anspruch 1 bis 8, dadurch gekennzeichnet, daß die Spalten der Zellen (C1 - C7) praktisch die ganze Oberfläche des Halbleiterplättchens einnehmen und

daß die Anzahl der Bereiche, die die zweite Gruppe von Leitern enthält, in der Mitte des Halbleiterplättchens größer ist, als am Umfang.

**FIG. 2**

**FIG. 2A**

**FIG. 1**

0001209

FIG. 3

FIG. 4

FIG. 6

|     | C1 | C2 | C3 | C4 | C5 |
|-----|----|----|----|----|----|
| R1  | A  | A  | A  | A  | A  |
| R2  | A  | A  | A  | A  | A  |
| R3  | A  | A  | A  | A  | A  |
| R4  | A  | A  | A  | A  | A  |
| R5  | A  | A  | A  | A  | A  |
| R6  | A  | A  | A  | A  | A  |
| R7  | A  | A  | A  | A  | A  |
| R8  | A  | A  | A  | A  | A  |
| R9  | A  | A  | A  | A  | A  |
| R10 | A  | A  | A  | A  | A  |
| R11 | W  | W  | W  | W  | W  |

**FIG. 5**

|     | C1  | C2 | C3 | C4 | C5 | C6    |
|-----|-----|----|----|----|----|-------|
| R1  | W   | A  | A  | A  | A  | A  W  |
| R2  | W   | A  | A  | A  | A  | A  W  |
| R3  | W   | A  | A  | A  | A  | A  W  |
| R4  | W   | A  | A  | A  | A  | A  W  |
| R5  | W   | A  | A  | A  | A  | W     |
| R6  | W   | A  | W  | A  | A  | W     |
| R7  | W   | A  | W  | A  | A  | W     |
| R8  | W   | A  | W  | A  | A  | A  W  |
| R9  | W   | A  | A  | A  | A  | A  W  |
| R10 | W   | A  | A  | A  | A  | A  W  |
| R11 | W   | A  | A  | A  | A  | A  W  |
| R12 | W   | A  | A  | A  | A  | A  W  |
| R13 | W  A | A  | A  | A  | A  | A  W  |
| R14 | W  A | A  | A  | A  | A  | A  W  |
| R15 | W   | W  | W  | W  | W  | W     |

**FIG. 7**

|     | C1 | C2 | C3 | C4 | C5 | C6 | C7 |
|-----|----|----|----|----|----|----|----|
| R1  | W  | A  | A  | A  | W  | A  | A  |
| R2  | W  | A  | A  | A  | W  | A  | A  |
| R3  | W  | A  | A  | A  | W  | A  | A  |
| R4  | W  | A  | A  | A  | W  | A  | A  |
| R5  | W  | A  | A  | A  | W  | A  | A  |
| R6  | W  | A  | A  | A  | W  | A  | A  |
| R7  | W  | A  | A  | A  | W  | A  | A  |
| R8  | W  | A  | A  | A  | W  | A  | A  |
| R9  | W  | W  | W  | W  | W  | W  | W  |
| R10 | W  | A  | A  | A  | W  | A  | A  |
| R11 | W  | A  | A  | A  | W  | A  | A  |
| R12 | W  | A  | A  | A  | W  | A  | A  |

**FIG. 8**

FIG. 9

FIG. 10

## EUROPÄISCHER RECHERCHENBERICHT

Europäisches Patentamt

Nummer der Anmeldung

EP 78 10 0054

### EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| X | ELECTRONICS, Band 42, No. 2, 20. Januar 1969, New York P.E. RODLEY "Metallization is designed quickly and inexpensively", Seiten 78-81. <br><br> * Seite 78, Spalte 2, Absatz "wiring real estate"; Seite 79, Figur "Placement"; Seite 80, Figur "Two layers"; Seite 81, Spalte 1 * | 1,4,5 8,10 |
| | IBM TECHNICAL DISCLOSURE BULLETIN, Band 20, Nr. 2, Juli 1977, New York, J.Z. CHEN et al. "Off-chip ground-up receiver", Seite 613-614. <br><br> * Seite 614, Figur 2 * | 7 |
| | IBM TECHNICAL DISCLOSURE BULLETIN, Band 20, Nr. 1, Juni 1977, New York B.C. FOX et al: "Slotted macro design structure" Seiten 186-188. <br><br> * Seite 186, Figur 1, Absatz 1 * | 1,4,5 |
| | DE - A - 2 659 246 (FUJITSU) <br><br> * Anspruch 3; Seite 7; Figur 1 * | 1,6 |
| | CH - A - 583 970 (IBM) <br><br> * Hauptanspruch; Unteranspruch 8; Spalte 5, Zeilen 49-55 * | 1 |
| | ./. | |

**KLASSIFIKATION DER ANMELDUNG (Int.Cl.²)**

H 01 L 23/52
23/50
27/02
27/10//
G 11 C 17/00

**RECHERCHIERTE SACHGEBIETE (Int.Cl.²)**

H 01 L 23/50
23/52
27/10
27/02

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Berlin | 06-12-1978 | ROTHER |

Europäisches
Patentamt

Nummer der Anmeldung

EP 78 10 0654
-2-

# EUROPÄISCHER RECHERCHENBERICHT

| | EINSCHLÄGIGE DOKUMENTE | | KLASSIFIKATION DER ANMELDUNG (Int.Cl.²) |
|---|---|---|---|
| Kategorie | Kennzeichnung des Dokuments mit Angabe, soweit erforderlich, der maßgeblichen Teile | betrifft Anspruch | |
| A | <u>GB − A − 1 443 363</u> (AMDAHL) | | |
| | | | |
| | ----- | | RECHERCHIERTE SACHGEBIETE (Int. Cl.²) |

EPA Form 1503.2 06.78